# EUROPEAN PATENT APPLICATION

(11) **EP 4 398 307 A1**
(43) Date of publication of application: **10.07.2024**
(21) Application number: 21959683.0
(22) Date of filing: 08.10.2021
(51) Int. Cl.: H01L 29/06

(54) **SEMICONDUCTOR DEVICE AND MANUFACTURING METHOD THEREFOR, AND ELECTRONIC DEVICE**

(71) Applicant: Huawei Technologies Co., Ltd., Shenzhen, Guangdong 518129 (CN)
(72) Inventor: YIN, Xiaogen, Shenzhen, Guangdong 518129 (CN); WAN, Guangxing, Shenzhen, Guangdong 518129 (CN); WONG, Waisum, Shenzhen, Guangdong 518129 (CN)
(74) Representative: Körber, Martin Hans
(86) International application number: PCT/CN2021/122568
(87) International publication number: WO 2023/056587

(57) **Abstract**

This application provides a semiconductor device and a manufacturing method therefor, and an electronic device, and relates to the field of semiconductor technologies. According to the semiconductor device manufacturing method, self-aligned spacers can be formed by using one manufacturing process. The semiconductor device manufacturing method includes: forming a semiconductor laminated structure on a substrate, where the semiconductor laminated structure includes channel layers and sacrificial layers that are alternately stacked; removing at least part of the sacrificial layers; manufacturing dummy gate layers at positions at which the sacrificial layers are removed and on a surface of the channel layer at the top layer, to form a fin structure; and using a same process step to simultaneously form spacers at two ends of the dummy gate layers.

## Description

### TECHNICAL FIELD

This application relates to the field of semiconductor technologies, and in particular, to a semiconductor device and a manufacturing method therefor, and an electronic device.

### BACKGROUND

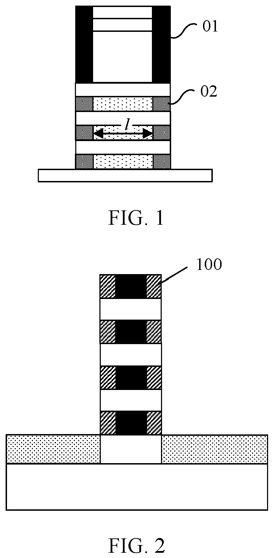

With continuous development of integrated circuit technology nodes, a lateral GAA-FET (lateral gate-all-around field effect transistor, lateral gate-all-around field effect transistor) becomes a key device to continue Moore's Law. FIG. 1 is a schematic diagram of a partial structure of a lateral GAA-FET according to a conventional technology. As shown in FIG. 1, in the lateral GAA-FET, in addition to a common spacer (spacer) 01 in a FinFET (fin field effect transistor, fin field effect transistor), an inner spacer (inner spacer) 02 is further disposed. The inner spacer 02 needs to be aligned with the spacer 01 above, to ensure that a plurality of gate lengths (*l*) of the lateral GAA-FET are consistent.

However, in the conventional technology, when the spacer 01 and the inner spacer 02 are manufactured, the spacer 01 is first formed, then a groove is formed through selective etching, and a medium is filled in the groove to form the inner spacer 02. In this case, to ensure that the spacer 01 is aligned with the inner spacer 02, requirements on etching precision and process variation (process variation) control of the groove formed through the selective etching are extremely high, which poses a great challenge to large-scale production.

### SUMMARY

Embodiments of this application provide a semiconductor device and a manufacturing method therefor, and an electronic device, so that self-aligned spacers can be formed by using one manufacturing process.

A semiconductor device manufacturing method provided by this application includes: forming a semiconductor laminated structure on a substrate, where the semiconductor laminated structure includes channel layers and sacrificial layers that are alternately stacked; removing at least part of the sacrificial layers; manufacturing dummy gate layers at positions at which the sacrificial layers are removed and on a surface of the channel layer at the top layer, to form a fin structure; and using a same process step to simultaneously form spacers at two ends of the dummy gate layers.

According to the semiconductor device manufacturing method provided in an embodiment of this application, the semiconductor laminated structure in which the channel layers and the sacrificial layers are alternately disposed is first manufactured, and after the sacrificial layers are removed, the dummy gate layers are manufactured at the positions at which the sacrificial layers are removed and on an upper surface of the semiconductor laminated structure, to form the fin structure; and then, the same process step is used to simultaneously form the spacers at the two ends of all the dummy gate layers. In this case, the spacers formed at the two ends of all the dummy gate layers use a same process parameter, to ensure that thicknesses of the spacers at the two ends of all the dummy gate layers are basically consistent, thereby implementing self-alignment (self-align) of the spacers.

In some possible implementations, the dummy gate layer includes a polysilicon material, and the spacer includes silicon nitride. In other words, the dummy gate layer is formed by using the polysilicon material, and polysilicon at two ends of the dummy gate layer is adjusted to silicon nitride by using a same subsequent process step, to form the spacer.

In some possible implementations, the using a same process step to simultaneously form spacers at two ends of all the dummy gate layers includes: simultaneously performing oxidation on two ends of each of the dummy gate layers to form initial spacers; and removing the initial spacers and filling silicon nitride, to form the spacers at the two ends of all the dummy gate layers. In this case, nitriding is simultaneously performed on all the dummy gate layers in the same process step. Because parameters (such as a time, a temperature, and a gas flow) for performing the nitriding on each dummy gate layer are the same, thicknesses of silicon nitride formed at the two ends of all the dummy gate layers are basically consistent, to ensure that thicknesses of the spacers at the two ends of all the dummy gate layers are basically consistent, thereby implementing self-alignment (self-align) of the spacers.

In some possible implementations, the using a same process step to simultaneously form spacers at two ends of all the dummy gate layers includes: simultaneously performing oxidation on two ends of each of the dummy gate layers to form initial spacers; and removing the initial spacers and filling silicon nitride, to form the spacers at the two ends of all the dummy gate layers. In this case, oxidation is simultaneously performed on the two ends of all the dummy gate layers in the same process step. Because parameters (such as a time, a temperature, and a gas flow) for performing the oxidation on each dummy gate layer are the same, thicknesses of silicon oxide formed at the two ends of all the dummy gate layers are basically consistent (that is, thicknesses of the initial spacers formed at the two ends of all the dummy gate layers are basically consistent). In this case, depths of grooves formed after the initial spacers are removed are basically consistent, so that thicknesses of silicon nitride filled in the grooves are also basically consistent to ensure that thicknesses of the spacers at the two ends of all the dummy gate layers are basically consistent, thereby implementing self-alignment (self-align) of the spacers.

In some possible implementations, the using a same process step to simultaneously form spacers at two ends of all the dummy gate layers includes: simultaneously performing etching on two ends of each of the dummy gate layers to form grooves, and filling the grooves with silicon nitride, to form the spacers at the two ends of all the dummy gate layers. In this case, etching is simultaneously performed on the two ends of all the dummy gate layers in the same process step. Because parameters (such as a time, a temperature, and a gas flow) for performing the etching on each dummy gate layer are the same, depths of grooves formed at the two ends of all the dummy gate layers are basically consistent, to ensure that thicknesses of silicon nitride filled in the grooves are basically consistent, and further ensure that thicknesses of the spacers at the two ends of all the dummy gate layers are basically consistent, thereby implementing self-alignment (self-align) of the spacers.

In some possible implementations, the manufacturing method further includes: forming a shallow trench isolation layer at the bottom of the fin structure. For example, in some embodiments, before the dummy gate layers are formed, first shallow trench isolation is first performed at the bottom of the semiconductor laminated structure, and after the fin structure is formed, second shallow trench isolation is performed, to form the shallow trench isolation layer at the bottom of the fin structure. For another example, in some embodiments, shallow trench isolation is performed on the bottom of the fin structure once, to form the shallow trench isolation layer.

In some possible implementations, before the manufacturing dummy gate layers at positions at which the sacrificial layers are removed and on a surface of the channel layer at the top layer, the manufacturing method further includes: performing oxidation on the surface of the channel layer to form an oxide layer. In this way, the channel layer can be protected by the oxide layer in a subsequent manufacturing process.

In some possible implementations, the substrate includes a silicon substrate.

In some possible implementations, a material for forming the channel layer includes Si (silicon); and a material for forming the sacrificial layer includes SiGe (silicon-germanium).

In some possible implementations, after the using a same process step to simultaneously form spacers at two ends of all the dummy gate layers, the manufacturing method further includes: epitaxially growing a source and a drain on two sides of the fin structure; and removing the dummy gate layers from the fin structure, and forming gates at positions at which the dummy gate layers are removed. For example, the gate may be a high-k metal gate (high-k metal gate, HKMG; or high dielectric coefficient metal gate layer).

An embodiment of this application further provides a semiconductor device, including a transistor disposed on a substrate. The transistor includes a fin structure and a source and a drain that are located on two sides of the fin structure. The fin structure includes at least two gates and a channel layer disposed between any two adjacent gates. Aligned spacers are disposed at two ends of all the gates. Materials of all the spacers are the same. An outer side surface of the spacer located at the top layer has a recess.

In a conventional technology, before a spacer at the top layer is formed, a mask layer is not formed on the surface of the fin structure, and the spacer is formed by directly etching a film layer that covers the surface of the fin structure. In this case, because an etching speed at a sharp corner of the film layer is fast, a sharp corner on the top of the spacer is rounded, that is, a rounded corner appears on the top of the spacer.

If the semiconductor device provided in this embodiment of this application is used, a same process step may be used to simultaneously form spacers at two ends of all dummy gate layers. In this case, the spacers formed at the two ends of all the dummy gate layers use a same process parameter, to ensure that thicknesses of the spacers at the two ends of all the dummy gate layers are basically consistent, thereby implementing self-alignment (self-align) of the spacers.

An embodiment of this application further provides an electronic device, including a printed circuit board and the semiconductor device provided in any one of the foregoing possible implementations, where the semiconductor device is connected to the printed circuit board.

### BRIEF DESCRIPTION OF DRAWINGS

FIG. 1 is a schematic diagram of a partial structure of a transistor according to a conventional technology of this application;
FIG. 2 is a schematic diagram of a partial structure of a semiconductor device according to an embodiment of this application;
FIG. 3 is a flowchart of a semiconductor device manufacturing method according to an embodiment of this application;
FIG. 4 is a schematic diagram of a structure of a semiconductor device in a manufacturing process according to an embodiment of this application;
FIG. 5 is a schematic diagram of a structure of a semiconductor device in a manufacturing process according to an embodiment of this application;
FIG. 6a is a schematic diagram of a structure of a semiconductor device in a manufacturing process according to an embodiment of this application;
FIG. 6b is a schematic diagram of a cross section of FIG. 6a along a position AA';
FIG. 7 is a schematic diagram of a structure of a semiconductor device in a manufacturing process according to an embodiment of this application;
FIG. 8 is a schematic diagram of a structure of a semiconductor device in a manufacturing process according to an embodiment of this application;
FIG. 9a is a schematic diagram of a structure of a semiconductor device in a manufacturing process according to an embodiment of this application;
FIG. 9b is a schematic diagram of a cross section of FIG. 9a along a position CC';
FIG. 10 is a schematic diagram of a structure of a semiconductor device in a manufacturing process according to an embodiment of this application;
FIG. 11 is a schematic diagram of a structure of a semiconductor device in a manufacturing process according to an embodiment of this application;
FIG. 12 is a schematic diagram of a structure of a semiconductor device in a manufacturing process according to an embodiment of this application;
FIG. 13 is a schematic diagram of a structure of a semiconductor device in a manufacturing process according to an embodiment of this application;
FIG. 14 is a schematic diagram of a structure of a semiconductor device in a manufacturing process according to an embodiment of this application;
FIG. 15 is a schematic diagram of a structure of a semiconductor device in a manufacturing process according to an embodiment of this application;
FIG. 16 is a schematic diagram of a shape of a spacer in a semiconductor device according to an embodiment of this application; and
FIG. 17 is a schematic diagram of a shape of a spacer in a semiconductor device according to a conventional technology of this application.

### DESCRIPTION OF EMBODIMENTS

To make the objectives, technical solutions, and advantages of this application clearer, the following clearly describes the technical solutions in this application with reference to the accompanying drawings in this application. It is clear that the described embodiments are merely a part rather than all of the embodiments of this application. All other embodiments obtained by a person of ordinary skill in the art based on embodiments of this application without creative efforts shall fall within the protection scope of this application.

In embodiments of this specification, claims, and the accompanying drawings of this application, terms such as "first" and "second" are only intended to distinguish between different objects, and should not be understood as an indication or implication of relative importance or as an indication or implication of order. Similar terms such as "connect" and "connected", used to express interworking or interaction between different components, may include a direct connection or an indirect connection through another component. In addition, terms "include", "have", or any other variant thereof are intended to cover a non-exclusive inclusion, for example, a series of steps or units are included. A method, system, product, or device is not necessarily limited to those steps or units that are clearly listed, but may include other steps or units that are not clearly listed or that are inherent to such a process, method, product, or device. "Upper", "lower", "left", "right", and the like are only used relative to orientations of components in the accompanying drawings. These orientation terms are relative concepts, which are used for description and clarification of the components, and may be correspondingly changed based on changes of the orientations of the components in the accompanying drawings.

It should be understood that in this application, "at least one (item)" refers to one or more and "a plurality of" refers to two or more. "And/or" is used to describe an association relationship between associated objects and indicates that three relationships may exist. For example, "A and/or B" may represent the following three cases: Only A exists, only B exists, and both A and B exist, where A and B may be singular or plural. The character "/" generally indicates an "or" relationship between associated objects. The expression "at least one of the following items (pieces)" or a similar expression means any combination of these items, including a single item (piece) or any combination of a plurality of items (pieces). For example, at least one item (piece) of a, b, or c may represent: a, b, c, "a and b", "a and c", "b and c", or "a and b and c", where a, b, and c may be singular or plural.

An embodiment of this application provides a semiconductor device. Afield effect transistor (field effect transistor, FET) is disposed in the semiconductor device. The field effect transistor (a transistor for short below) may be a lateral gate-all-ground field effect transistor (lateral gate-all-around field effect transistor, lateral GAA-FET), a forksheet field effect transistor (forksheet field effect transistor, forksheet-FET), a complementary field effect transistor (complementary field effect transistor, CFET), or the like. This is not specifically limited in this application. The following embodiments are described by using an example in which the transistor is a lateral GAA-FET.

FIG. 2 is a schematic diagram of a partial structure of a transistor according to an embodiment of this application. As shown in FIG. 2, all spacers (spacers) in the transistor provided in this embodiment of this application are simultaneously manufactured by using a same manufacturing process (or a same process step), that is, process parameters for forming all the spacers are the same, so that all the spacers can implement self-alignment (self-align), thereby avoiding a problem in a conventional technology that a process variation control requirement is high because a spacer located at the top layer and an inner spacer not at the top layer are respectively formed by using two processes.

A disposition form of the semiconductor device in which the transistor is disposed is not limited in this application. For example, the semiconductor device may be a chip a sensor, or the like.

The following schematically describes, with reference to a transistor manufacturing process, a manufacturing process of forming self-aligned spacers 100 in a semiconductor device according to an embodiment of this application.

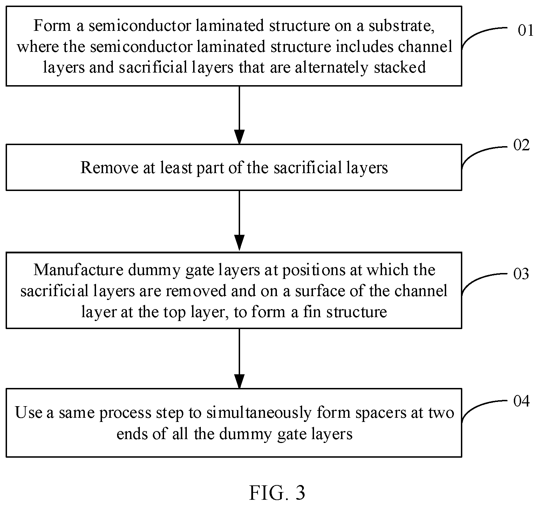

As shown in FIG. 3, an embodiment of this application provides a semiconductor device manufacturing method. The manufacturing method includes:

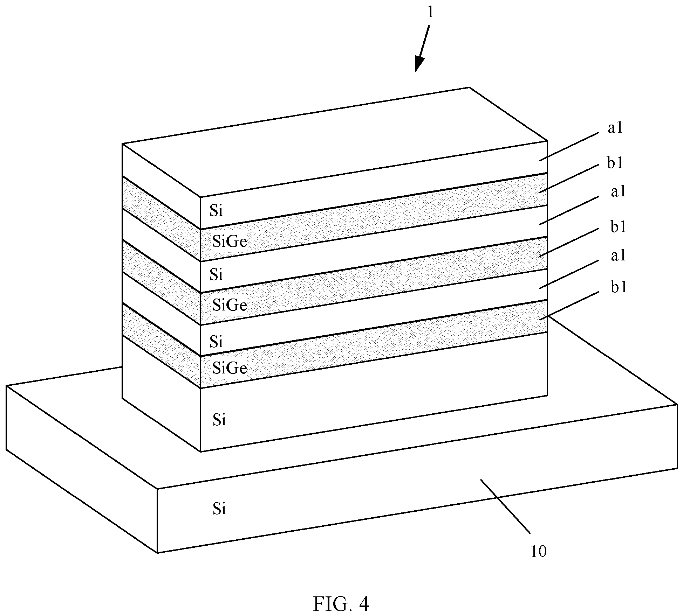

Step 01: With reference to FIG. 4, form a semiconductor laminated structure 1 on a substrate 10, where the semiconductor laminated structure 1 includes channel layers a1 and sacrificial layers b 1 that are alternately stacked.

It should be noted that the channel layers a1 in the semiconductor laminated structure 1 finally form channels of a transistor by using a subsequent manufacturing process, gates of the transistor are finally formed at positions of the sacrificial layers b1 by using a subsequent manufacturing process, and spacers are formed at two ends of the gates along a length direction. Therefore, in the foregoing semiconductor laminated structure 1, one channel layer a1 may be disposed on an upper surface of each sacrificial layer b 1, to ensure that a channel can be formed on a surface of each gate in a manufactured transistor.

For example, the substrate 10 may be a silicon (Si) substrate (also referred to as a silicon substrate); and the channel layer a1 may be made of a Si (silicon) material, and the sacrificial layer b1 may be made of a SiGe (silicon-germanium) material. However, this is not limited thereto. The following embodiments are described by using this as an example.

For example, with reference to FIG. 4, in some possible implementations, step 01 may include: sequentially manufacturing a Si layer, a SiGe layer, a Si layer, a SiGe layer, a Si layer, and a SiGe layer on the Si substrate (that is, 10), and then forming a plurality of semiconductor laminated structures 1 through etching and segmentation. In the semiconductor laminated structure 1, the Si layers are used as the channel layers a1, and the SiGe layers are used as the sacrificial layers b1.

It should be noted herein that, with reference to FIG. 4, when the semiconductor laminated structure 1 is formed by performing etching on a plurality of semiconductor layers formed on the Si substrate (10) in step 01, the Si substrate (10) is etched to some extent. In this case, the Si layer at the bottom of the semiconductor laminated structure 1 is formed by etching the Si substrate, and this part (namely, the Si layer at the bottom of the semiconductor laminated structure 1) may not be used as a channel layer a1.

Certainly, materials of the channel layer a1 and the sacrificial layer b1 are not limited to the foregoing Si and SiGe, provided that the channel layer a1 and the sacrificial layer b1 satisfy selective etching. For example, the channel layer a1 may use Si₁₋ₓGeₓ, and the sacrificial layer b1 may use Si_{1-y}Ge_{y}, where x and y are not equal. For example, the channel layer a1 may use Si_{0.7}Ge_{0.3}, and the sacrificial layer b1 may use Si_{0.4}Ge_{0.6}, that is, x=0.3 and y=0.6. For another example, the channel layer a1 may use InGaAs, the sacrificial layer b1 may use GaAs, and the like. This is not limited in this application. In practice, the materials may be selected as required.

In addition, it should be further noted that FIG. 4 is described merely by using an example in which one semiconductor laminated structure 1 on the substrate 10 is. According to an actual requirement, two or more semiconductor laminated structures 1 may be formed by performing step 01.

A person skilled in the art should understand that each semiconductor laminated structure 1 formed by performing step 01 is used as an active area (active area) and is subsequently used to form a transistor. One semiconductor laminated structure 1 may form at least one transistor by using a subsequent manufacturing process, for example, two or more transistors.

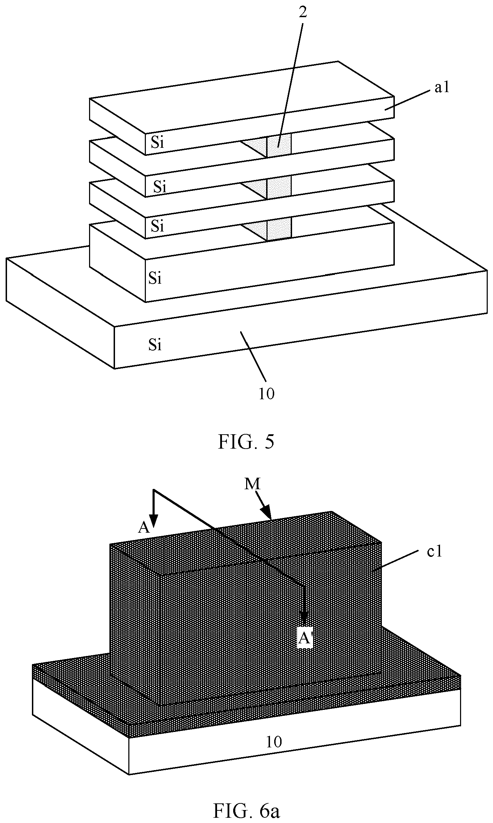

Step 02: With reference to FIG. 5, remove at least part of the sacrificial layers b1.

It may be understood herein that an objective of step 02 is to remove the sacrificial layers b1. However, to provide support for the channel layers a1, the sacrificial layer b 1 in a part of an area between two channel layers a1 is reserved as a support structure 2 (self-holder) of the channel layers.

For example, with reference to FIG. 5, in some possible implementations, isotropic selective etching may be performed on the sacrificial layer b 1 that uses SiGe in step 02, and a part of the sacrificial layer b 1 is reserved as the support structure 2 for the channel layer a1 by controlling an etching degree.

It may be understood that both an upper surface (namely, a surface away from the substrate) and a lower surface (namely, a surface close to the substrate) of a sacrificial layer b1 that is located outside the support structure 2 can be exposed by removing the sacrificial layers b1 in step 02.

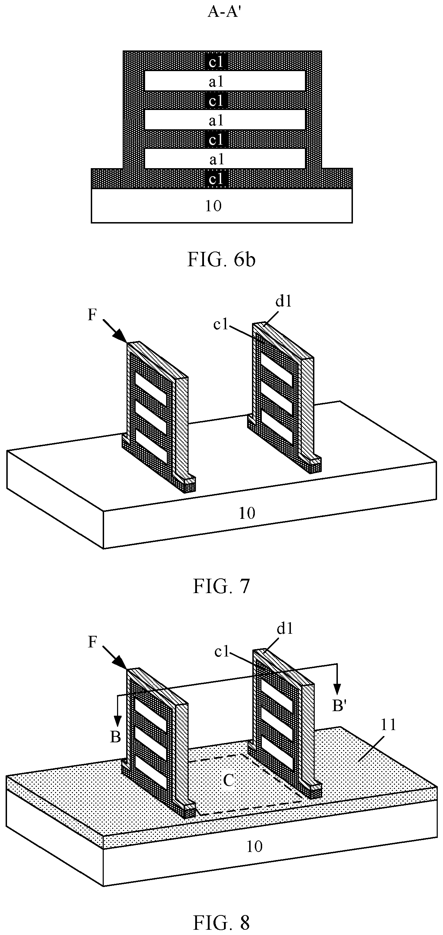

Step 03: With reference to FIG. 6a and FIG. 6b (a schematic diagram of a cross section of FIG. 6a along a position AA'), manufacture dummy gate layers c1 (also referred to as dummy gates) at positions at which the sacrificial layers b1 are removed and on a surface of the channel layer at the top layer, to form a fin structure F (refer to FIG. 7).

For example, in some possible implementations, with reference to FIG. 6a, a polysilicon material may be deposited at the positions at which the sacrificial layers b1 are removed and on the surface of the channel layer a1 at the top layer to form the dummy gate layers c1, so as to form an intermediate laminated structure M. Then, with reference to FIG. 7, a hard mask layer d1 is deposited on a surface of the intermediate laminated structure M, and the intermediate laminated structure M is segmented through etching to form the fin structure F.

It may be understood herein that a gate length and a gate width of a transistor are preliminarily defined in an etching process in which the fin structure F is formed in step 03.

In addition, in the process of performing segmentation through etching and forming the fin structure F in step 03, the support structures 2 formed in step 02 may be removed.

It should be noted that a dummy gate material for forming the dummy gate layers c1 in step 03 may be a polysilicon material (polysilicon, poly-Si), but this is not limited thereto. For example, in some possible implementations, the dummy gate material may alternatively be amorphous silicon, silicon oxide, or the like. In practice, the dummy gate material may be selected as required. The following embodiments are all described by using an example in which the dummy gate material is the polysilicon material.

In addition, to form isolation between adjacent fin structures F and ensure that subsequently formed transistors can work independently, in some possible implementations, as shown in FIG. 8, shallow trench isolation (shallow trench isolation, STI) may be performed on the bottom of the fin structure F, to form a shallow trench isolation layer 11 at the bottom of the fin structure F.

For example, in some embodiments, the shallow trench isolation layer 11 may use silicon oxide, but this is not limited thereto.

A manufacturing manner of the shallow trench isolation layer 11 is not limited in this application, and the shallow trench isolation layer 11 may be actually made as required.

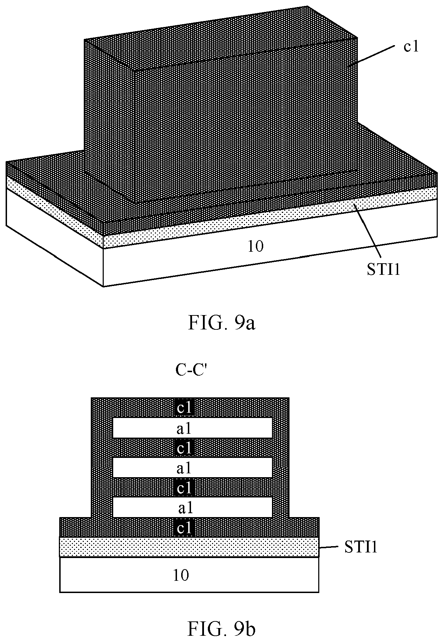

For example, in some possible implementations, as shown in FIG. 9a and FIG. 9b (a cross-sectional view of FIG. 9a along a position CC'), before the dummy gate layers c1 are formed in step 03, first shallow trench isolation (STI1) may be first performed at the bottom of the semiconductor laminated structure 1. As shown in FIG. 8, in the process of forming the fin structure F in step 03, a part (namely, a part of an area C) between two adjacent fin structures F needs to be removed, so that the area C between the two adjacent fin structures F is not isolated. Therefore, after the fin structure F is formed in step 03, second shallow trench isolation (STI2) needs to be performed, to form a shallow trench isolation layer 11 at the bottom of the fin structure F.

For another example, in some possible implementations, as shown in FIG. 7 and FIG. 8, after the fin structure F is formed in step 03, shallow trench isolation is performed on the bottom of the fin structure F once to form the shallow trench isolation layer 11.

Compared with the manufacturing manner in which shallow trench isolation is performed twice, the manufacturing manner in which shallow trench isolation is performed once has an advantage that a manufacturing process is simple. Compared with the manner in which shallow trench isolation is performed once, as shown in FIG. 9b, the manner in which shallow trench isolation is performed twice can ensure that a shallow trench isolation layer 11 exists below the dummy gate layer c1 at the bottom layer. Subsequently, after the dummy gate layer c1 is replaced with a gate (refer to related description in the following), the shallow trench isolation layer 11 is also reserved between the gate and the substrate 10, to ensure isolation between the gate and the substrate 10. Certainly, in the manner in which shallow trench isolation is performed once, when the dummy gate layer c 1 is replaced with a gate, a part of the dummy gate layer c1 may be reserved, to ensure isolation between the gate and the substrate 10.

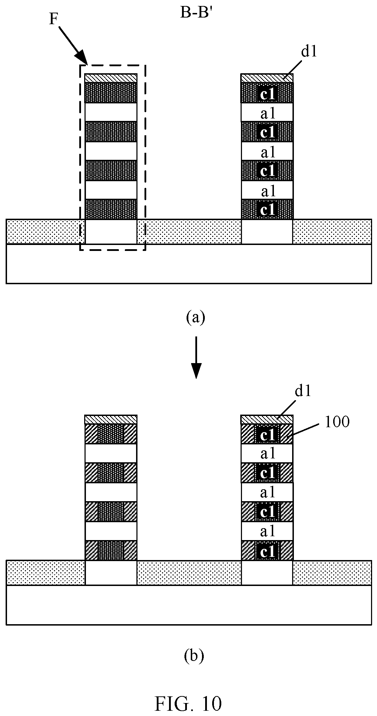

In addition, in some possible implementations, before the dummy gate layers c1 are formed in step 03, oxidation may be first performed on surfaces of the channel layers a1, to form an oxide layer (not shown in FIG. 6 and FIG. 7) on the surfaces of the channel layers a1 (such as Si layers), so that the oxide layer provides protection for the channel layers a1 in a subsequent manufacturing process. Step 04: (a) in FIG. 10 is a schematic diagram of a cross section of FIG. 8 along a position BB'. As shown in FIG. 10, in a same process step (that is, a same manufacturing process is used), spacers 100 are simultaneously formed at two ends of all the dummy gate layers c1.

A person skilled in the art should understand that the spacers at the two ends of the dummy gate layers c1 (namely, the dummy gate layers that are not at the top layer) inside the fin structure F may also be referred to as inner spacers (inner spacers).

It should be noted that the "same process step" is to perform a related manufacturing process by using one process or simultaneously perform a related manufacturing process by using a plurality of processes.

For example, the following provides three manufacturing manners of forming the spacers 100 at the two ends of the dummy gate layers c1 by using an example in which the dummy gate layers c1 are made of a polysilicon material and the spacers 100 are made of a silicon nitride (SiN) material.

### Manufacturing manner 1

In some possible implementations, as shown in (a) and (b) in FIG. 10, nitriding is simultaneously performed on two ends of each dummy gate layer c 1. Silicon nitride is formed after nitriding of polysilicon at the two ends of the dummy gate layers c1 (in a channel length direction), so that the spacers 100 formed by the silicon nitride are formed on both sides of all the dummy gate layers c1.

In the manufacturing manner 1, nitriding is simultaneously performed on all the dummy gate layers in a same process step. Because parameters (such as a time, a temperature, and a gas flow) for performing the nitriding on each dummy gate layer are the same, thicknesses of silicon nitride formed at the two ends of all the dummy gate layers are basically consistent, to ensure that thicknesses of the spacers 100 at the two ends of all the dummy gate layers are basically consistent, thereby implementing self-alignment (self-align) of the spacers.

### Manufacturing manner 2

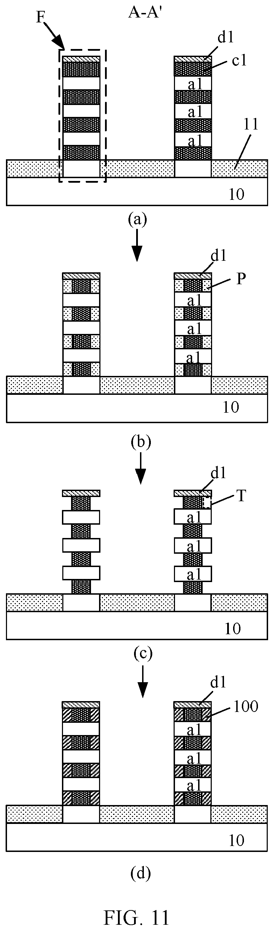

In some possible implementations, as shown in (a) and (b) in FIG. 11, oxidation is simultaneously performed on two ends of each dummy gate layer c1. Polysilicon located at the two ends of each dummy gate layer c1 is oxidized to silicon oxide, to form initial spacers P formed by the silicon oxide. Next, as shown in (b) and (c) in FIG. 11, the initial spacers P are removed to form grooves T. Then, as shown in (c) and (d) in FIG. 11, silicon nitride is filled in all formed grooves T, so that the spacers 100 formed by the silicon nitride are formed at the two ends of all the dummy gate layers c1.

In the manufacturing manner 2, oxidation is simultaneously performed on the two ends of all the dummy gate layers in a same process step. Because parameters (such as a time, a temperature, and a gas flow) for performing the oxidation on each dummy gate layer are the same, thicknesses of silicon oxide formed at the two ends of all the dummy gate layers are basically consistent (that is, thicknesses of the initial spacers P formed at the two ends of all the dummy gate layers are basically consistent). In this case, depths of the grooves T formed after the initial spacers P are removed are basically consistent, so that thicknesses of silicon nitride filled in the grooves T are also basically consistent, to ensure that thicknesses of the spacers at the two ends of all the dummy gate layers are basically consistent, thereby implementing self-alignment (self-align) of the spacers.

### Manufacturing manner 3

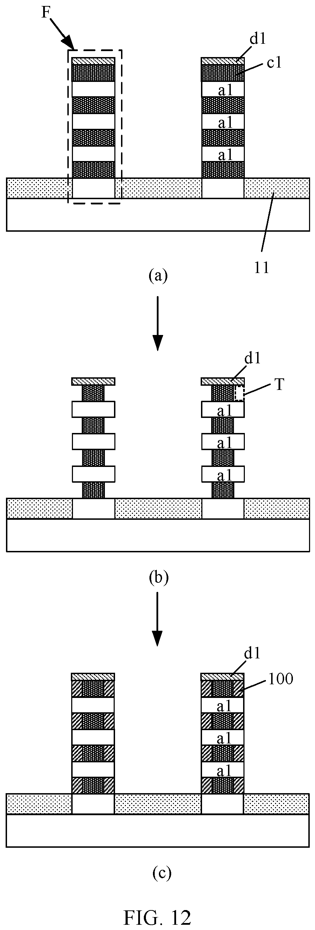

In some possible implementations, as shown in (a) and (b) in FIG. 12, etching may be simultaneously performed on two ends of each dummy gate layer c1 to form grooves T. Next, as shown in (b) and (c) in FIG. 12, silicon nitride is filled in the grooves T, so that the spacers 100 formed by the silicon nitride are formed at the two ends of all the dummy gate layers c1.

In the manufacturing manner 3, etching is simultaneously performed on the two ends of all the dummy gate layers in a same process step. Because parameters (such as a time, a temperature, and a gas flow) for performing the etching on each dummy gate layer are the same, depths of the grooves T formed at the two ends of all the dummy gate layers are basically consistent, to ensure that thicknesses of silicon nitride filled in the grooves T are basically consistent, and further ensure that thicknesses of the spacers at the two ends of all the dummy gate layers are basically consistent, thereby implementing self-alignment (self-align) of the spacers.

It should be noted that all the foregoing embodiments are described by using an example in which the spacers 100 use SiN. However, this application is not limited thereto. For example, in some possible implementations, the spacers 100 may alternatively use a SiN-SiCO laminated structure. For another example, in some possible implementations, the spacers 100 may alternatively use SiO₂. In practice, a proper manufacturing process may be selected based on a specific material of the dummy gate layers c1 to form the spacers 100.

In conclusion, according to the semiconductor device manufacturing method provided in this embodiment of this application, a semiconductor laminated structure in which channel layers and sacrificial layers are alternately disposed is first manufactured, and after the sacrificial layers are removed, the dummy gate layers are manufactured at positions at which the sacrificial layers are removed and on an upper surface of the semiconductor laminated structure, to form a fin structure; and then, a same process step is used to simultaneously form spacers at two ends of all the dummy gate layers. In this case, the spacers formed at the two ends of all the dummy gate layers use a same process parameter, to ensure that thicknesses of the spacers at the two ends of all the dummy gate layers are basically consistent, thereby implementing self-alignment (self-align) of the spacers.

It may be understood that, with reference to FIG. 1, in a conventional technology, a material of a dummy gate layer (namely, a dummy gate layer at the top layer) located on an inner side of the spacer 01 and a material of a dummy gate layer (namely, an internal dummy gate layer) located on an inner side of the inner spacer 02 are different, and this results in that materials of the channel layer, the dummy gate layer at the top layer, and the internal dummy gate layer are different. Therefore, a condition of selective etching cannot be met (selective etching usually needs to be performed between two different materials). As a result, the spacer 01 and the inner spacer 02 need to be manufactured separately.

In comparison, according to the manufacturing method provided in this embodiment of this application, all the dummy gate layers c1 use a same material, so that selective etching can be performed on the dummy gate layers c1 and the channel layers a1, and it is possible to manufacture all spacers through a same process step.

In addition, according to the semiconductor device manufacturing method provided in this embodiment of this application, a same process step is used to synchronously form all spacers, thereby simplifying a process flow, and reducing variations of a gate length, a source-drain resistor, a source-drain parasitic capacitor, and the like. The manufacturing method can adapt to large-scale industrial production.

For manufacturing of a transistor in a semiconductor device, it may be understood that after the spacers 100 are manufactured, components such as a source and a drain further need to be manufactured.

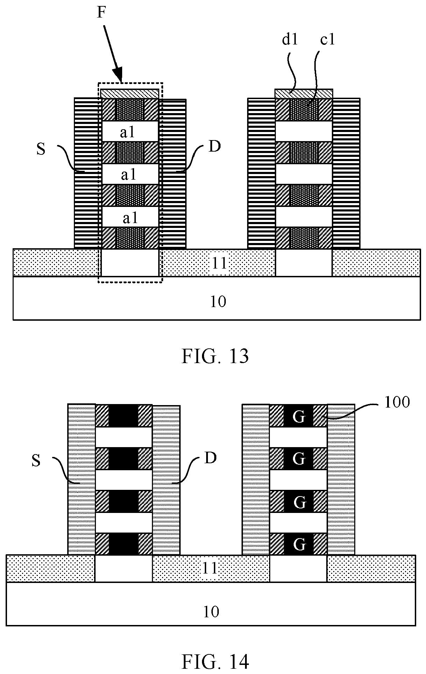

For example, in some possible implementations, after step 04, the semiconductor device manufacturing method provided in this embodiment of this application may further include:
Step 05: With reference to FIG. 13, epitaxially grow a source S (source) and a drain D (drain) on two sides of the fin structure F.

For example, in some possible implementations, an epitaxial growth process may be used to perform source-drain epitaxial growth of an N-type transistor/a P-type transistor on a side surface of the channel layer a1 (for example, a Si layer) in the fin structure F.

Step 06: With reference to FIG. 13 and FIG. 14, remove the dummy gate layers c1 from the fin structure F, and form gates G (gates) at positions at which the dummy gate layers c1 are removed.

For example, in some possible implementations, a high-k metal gate (high-k metal gate, HKMG, high dielectric coefficient metal gate layer) may be deposited at the positions at which the dummy gate layers c1 are removed. That is, the dummy gate layers c1 are replaced with the gates G by using a replacement metal gate (replacement metal gate, RMG) technology.

Schematically, in some possible implementations, as shown in FIG. 13 and FIG. 14, in step 06, a hard mask layer d1 located at the top of the fin structure F may be first removed, then the dummy gate layers c1 that use a polysilicon material and that are located inside the fin structure F are removed by using isotropic etching, and a high-k metal gage (that is, G) is deposited at the positions at which the dummy gate layers c1 are removed.

Certainly, after step 05 and before step 06, an interlayer dielectric (interlayer dielectric, ILD) may be deposited in an area between the source S and the drain D, which is not shown in FIG. 11 and FIG. 12.

In this way, a front-end process of the semiconductor device is completed. For a middle-end process and a back-end process of the semiconductor device, refer to a conventional technology. Details are not described herein again.

An embodiment of this application further provides a semiconductor device. The semiconductor device may be manufactured by using any one of the foregoing possible semiconductor device manufacturing methods, but this is not limited thereto.

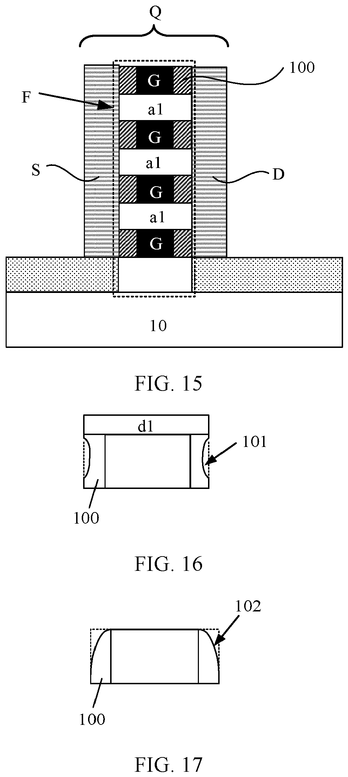

As shown in FIG. 15, the semiconductor structure includes a transistor Q disposed on a substrate 10. The transistor Q includes a fin structure F and a source S and a drain D that are located on two sides of the fin structure F. The fin structure F includes at least two gates G (gates) disposed in layers, and a channel layer a1 disposed between any two adjacent gates G.

In addition, spacers 100 are disposed at two ends of all gates G along a channel length direction, the spacers 100 at the two ends of all the gates G are aligned, and materials of all the spacers 100 are the same.

For example, in some possible implementations, all the spacers 100 may use silicon nitride (SiN).

For example, in some possible implementations, the channel layer a1 may be a silicon layer.

For example, in some possible implementations, all the gates G may use a high-k metal gate.

In addition, in some semiconductor devices provided in an embodiment of this application, an outer surface of the spacer 100 located at the top layer has a recess. With reference to the semiconductor device manufacturing method provided in embodiments of this application, the following describes the recess on the outer surface of the spacer 100 located at the top layer in this application.

With reference to the foregoing manufacturing manner 2 and the manufacturing manner 3, as shown in (c) and (d) in FIG. 11 and (b) and (c) in FIG. 12, when the spacers 100 are manufactured, a film layer needs to be deposited before etching is performed to form the spacers 100 in the grooves T. In this case, with reference to FIG. 16, before the spacers 100 are manufactured, a hard mask layer d1 is first manufactured on the surface of the fin structure in step 03. Based on a mask function of the hard mask layer d1, when the spacers 100 at the top layer (that is, spacers at two ends of the gate at the top layer) are formed by using an etching process, an etching speed in an area that is of an outer side surface (that is, a surface away from the gate G) of the spacer 100 at the top layer and that is close to the hard mask layer d1 is slow. However, specific over-etching may occur in a middle area due to transverse drilling and etching. Therefore, an outer surface of the finally formed spacer 100 at the top layer has a recess 101.

However, in a conventional technology, with reference to FIG. 17, before the spacer 100 at the top layer is formed, a mask layer is not formed on the surface of the fin structure, and the spacer 100 is formed by directly etching a film layer that covers the surface of the fin structure. In this case, because an etching speed at a sharp corner of film layer is fast, a sharp corner on the top of the spacer 100 is rounded, that is, a rounded corner 102 appears on the top of the spacer 100.

For other related content of the foregoing semiconductor device, correspondingly refer to corresponding parts in the foregoing semiconductor device manufacturing method embodiment, and details are not described herein again. Alternatively, correspondingly refer to the foregoing chip manufacturing method embodiment and perform proper adjustment with reference to a conventional technology. This is not limited in this application.

An embodiment of this application further provides an electronic device. The electronic device includes a printed circuit board (printed circuit Board, PCB) and the semiconductor device provided in any one of the foregoing possible implementations. The semiconductor device is disposed on the PCB and is electrically connected to the PCB.

The electronic device may be an electronic product such as a mobile phone, a tablet computer, a notebook computer, a vehicle-mounted computer, a smart watch, or a smart band. A specific form of the electronic device is not specially limited in this embodiment of this application.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor device manufacturing method, comprising:
forming a semiconductor laminated structure on a substrate, wherein the semiconductor laminated structure comprises channel layers and sacrificial layers that are alternately stacked;
removing at least part of the sacrificial layers;
manufacturing dummy gate layers at positions at which the sacrificial layers are removed and on a surface of the channel layer at a top layer, to form a fin structure; and
using a same process step to simultaneously form spacers at two ends of all the dummy gate layers.

2. The semiconductor device manufacturing method according to claim 1, wherein
the dummy gate layer comprises a polysilicon material; and
the spacer comprises silicon nitride.

3. The semiconductor device manufacturing method according to claim 2, wherein
the using a same process step to simultaneously form spacers at two ends of all the dummy gate layers comprises:
simultaneously performing oxidation on two ends of each of the dummy gate layers to form initial spacers; and
removing the initial spacers and filling silicon nitride, to form the spacers at the two ends of all the dummy gate layers.

4. The semiconductor device manufacturing method according to claim 2, wherein
the using a same process step to simultaneously form spacers at two ends of all the dummy gate layers comprises:
simultaneously performing nitriding on two ends of each of the dummy gate layers, to form the spacers at the two ends of all the dummy gate layer.

5. The semiconductor device manufacturing method according to claim 2, wherein
the using a same process step to simultaneously form spacers at two ends of all the dummy gate layers comprises:
simultaneously performing etching on two ends of each of the dummy gate layers to form grooves, and filling the grooves with silicon nitride, to form the spacers at the two ends of all the dummy gate layers.

6. The semiconductor device manufacturing method according to any one of claims 1 to 5, wherein the manufacturing method further comprises:
forming a shallow trench isolation layer at a bottom of the fin structure.

7. The semiconductor device manufacturing method according to any one of claims 1 to 6, wherein before the manufacturing dummy gate layers at positions at which the sacrificial layers are removed and on a surface of the channel layer at a top layer, to form a fin structure, the manufacturing method further comprises:
performing oxidization on the surface of the channel layer to form an oxide layer.

8. The semiconductor device manufacturing method according to any one of claims 1 to 7, wherein
the substrate comprises a silicon substrate.

9. The semiconductor device manufacturing method according to any one of claims 1 to 8, wherein
a material for forming the channel layer comprises Si; and
a material for forming the sacrificial layer comprises SiGe.

10. The semiconductor device manufacturing method according to any one of claims 1 to 9, wherein
after the using a same process step to simultaneously form spacers at two ends of all the dummy gate layers, the manufacturing method further comprises:
epitaxially growing a source and a drain on two sides of the fin structure; and
removing the dummy gate layers from the fin structure, and forming gates at positions at which the dummy gate layers are removed.

11. A semiconductor device, comprising a transistor disposed on a substrate, wherein the transistor comprises a fin structure and a source and a drain that are located on two sides of the fin structure;
the fin structure comprises at least two gates and a channel layer disposed between any two adjacent gates;
aligned spacers are disposed at two ends of all the gates;
materials of all the spacers are the same; and
an outer side surface of the spacer located at a top layer has a recess.
